(19) 

**Europäisches Patentamt**
**European Patent Office**
**Office européen des brevets**

(11) **EP 4 111 219 B1**

(12) **FASCICULE DE BREVET EUROPEEN**

(45) Date de publication et mention
de la délivrance du brevet:
**03.04.2024 Bulletin 2024/14**

(21) Numéro de dépôt: **21701819.1**

(22) Date de dépôt: **01.02.2021**

(51) Classification Internationale des Brevets (IPC):
**G01R 31/382** *(2019.01)*    **G01R 31/392** *(2019.01)*
**G01R 31/36** *(2020.01)*

(52) Classification Coopérative des Brevets (CPC):
**G01R 31/392; G01R 31/3648;** Y02T 10/70

(86) Numéro de dépôt international:
**PCT/EP2021/052308**

(87) Numéro de publication internationale:
**WO 2021/170345 (02.09.2021 Gazette 2021/35)**

(54) **PROCÉDÉ D'ESTIMATION DE L'ÉTAT DE SANTÉ ÉNERGÉTIQUE D'UNE BATTERIE**

VERFAHREN ZUR SCHÄTZUNG DES INTAKTHEITSSTATUS EINER BATTERIE

METHOD FOR ESTIMATING THE STATE OF HEALTH OF A BATTERY

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:  **26.02.2020   FR 2001868**

(43) Date de publication de la demande:
**04.01.2023   Bulletin 2023/01**

(73) Titulaire: **Renault s.a.s**
**92100 Boulogne Billancourt (FR)**

(72) Inventeurs:
  • **EDDAHECH, Akram**
  **78280 Guyancourt (FR)**
  • **MAWONOU, Kodjo-Senou-Rodolphe**
  **78990 Elancourt (FR)**

(56) Documents cités:
  **WO-A1-2015/169717     FR-A1- 2 967 786
  US-A1- 2009 128 097     US-A1- 2011 112 781
  US-B2- 10 401 433**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 4 111 219 B1

**Description**

La présente invention concerne un procédé d'estimation de l'état de santé d'une batterie. Elle concerne plus particulièrement les batteries prévues pour alimenter les véhicules automobiles électriques ou hybrides.

La détermination de l'état de santé, ou du vieillissement, d'une batterie est un critère essentiel pour caractériser l'état d'une batterie, afin d'optimiser la décharge/charge d'énergie, ainsi que la durée de vie des accumulateurs de la batterie.

Dans la présente demande, par état de santé d'une batterie, on entend un indicateur de l'état de santé énergétique d'une batterie, ou SOHE (de l'anglais "State Of Health Energy"), estimé à un instant donné, rendant compte du niveau de dégradation de l'autonomie de la batterie, du fait notamment de l'âge de la batterie et des conditions d'utilisation de cette dernière.

Une fois que ce paramètre atteint une valeur seuil, la batterie est jugée trop vieille et peut être retirée du circuit d'utilisation pour une utilisation stationnaire en seconde vie par exemple. Le SOHE est également utilisé pour d'autres calculs internes propres au BMS (de l'anglais « Battery Management System »). Pour rappel, le BMS est un système électronique permettant de gérer et de contrôler les différents paramètres d'une batterie, comme par exemple son état de charge ou SOC (de l'anglais « State Of Charge »).

Les calculs du SOHE sont habituellement assurés par le BMS lors de l'utilisation de la batterie, notamment en période de décharge quand le véhicule roule ou en période de charge quand le véhicule est branché à une borne de recharge. On parle alors d'estimation « en ligne » de l'état de santé de la batterie ou « onboard » selon la terminologie anglo-saxonne, car l'estimation est faite par le BMS embarqué de manière autonome. Or, il arrive bien souvent que ces calculs en ligne ne soient pas très fiables, avec parfois des écarts relativement importants observés par rapport à la véritable valeur du SOHE.

L'état de santé d'une batterie peut être quantifié par différentes grandeurs. Les plus utilisées sont les évolutions de capacité, de résistance ou encore de l'impédance de la batterie étudiée.

Quel que soit le paramètre utilisé pour le définir, l'état de santé d'une batterie doit être connu avec précision afin d'éviter le risque d'une défaillance intempestive, ou d'une dégradation inattendue des performances du système alimenté par ladite batterie. Cela est particulièrement important dans le cas des batteries des véhicules automobiles électriques ou hybrides. Egalement, selon le constructeur, le véhicule électrique peut être commercialisé sans sa batterie. Celle-ci fait alors l'objet d'un contrat de location/maintenance séparé. Dans ce contexte, l'état de santé de la batterie est une donnée d'entrée majeure pour la garantie incluse dans le contrat de location/ maintenance de la batterie.

En raison de l'importance technique et économique du problème, de très nombreuses méthodes d'estimation de l'état de santé d'une batterie ont été proposées. On connaît ainsi du document US2011112781, une méthode d'estimation de l'état de santé d'une batterie de véhicule sur la base de grandeurs dynamiques relatives au comportement de la batterie, collectées à partir d'un système de gestion de la batterie pourvu de capteurs, et notamment de grandeurs concernant le SOC et la température. Selon un exemple de réalisation, la méthode utilise un premier algorithme, dit temporel, et un second algorithme, dit évènementiel, pour estimer l'état de santé de la batterie. L'algorithme temporel reçoit les grandeurs collectées, par exemple le SOC, sur une base périodique (par exemple, une fois par milliseconde, une fois par seconde, etc.), et fournit une sortie correspondante. L'algorithme évènementiel peut extraire certaines données des grandeurs collectées de la batterie, typiquement des données relatives à la variation du SOC, et les comparer à une valeur maximale ou minimale du SOC, et fournit une sortie correspondante. Les sorties des algorithmes temporel et événementiel sont ensuite combinées pour estimer l'état de santé énergétique de la batterie.

L'intérêt de cette méthode en ligne est de compenser les limites de l'algorithme temporel, qui peut en effet ne pas prendre en compte certains événements intra-échantillonnage qui peuvent se produire, dans la mesure où cet algorithme utilise simplement les informations de batterie échantillonnées périodiquement comme entrées. Typiquement, si le SOC des cellules de la batterie est acquis toutes les secondes et que le SOC devait momentanément culminer entre deux acquisitions, alors cette information ne serait pas prise en compte par l'algorithme temporel, ce qui pourrait affecter la prévision globale de l'état de santé. L'algorithme évènementiel vient y pallier en prenant en entrée une variation d'état de charge à un moment donné et sa comparaison à une valeur connue précédente.

Cependant, la précision de l'estimation obtenue n'est pas fiable au cours de la durée de vie de la batterie et il existe un risque de dérive important de l'estimation selon les données d'usage particulières de la batterie, c'est-à-dire en fonction des conditions particulières d'utilisation de la batterie. Cette estimation ne permet pas de sélectionner les valeurs du SOHE calculées, qui soient les plus proches possibles de la véritable valeur de ce paramètre, et ainsi d'éliminer les valeurs qui en seraient éloignées.

Autrement dit il existe un besoin pour pouvoir s'affranchir d'une dérive potentielle de l'estimation en ligne de l'état de santé énergétique de la batterie.

D'autres documents pertinents pour l'état de la technique sont FR 2 967 786 A1, WO 2015/169717 A1, US 2009/128097 A1 et US 10 401 433 B2.

Un but de l'invention est de proposer une estimation de l'état de santé énergétique d'une batterie, en particulier d'une batterie équipant un véhicule électrique ou hybride, qui soit précise tout au long de l'usage de la batterie en prenant en compte les conditions particulières d'utilisation de la batterie.

A cette fin, l'invention concerne un procédé d'estimation de l'état de santé énergétique d'une batterie d'un véhicule électrique ou hybride comprenant une étape de calcul dudit état de santé à partir d'au moins un paramètre mesuré sur la batterie, dont son état de charge, le procédé étant caractérisé en ce qu'il comprend des étapes de :

- sélectionner un cas d'usage typique du véhicule, incluant des occurrences de décharge correspondant toujours à sensiblement une même distance de roulage ou des occurrences de charge correspondant toujours à sensiblement une même durée de recharge à une borne de recharge, chaque occurrence de décharge ou de charge étant suivie d'une période de repos supérieure à un temps de relaxation donné de la batterie ;
- déterminer une valeur témoin représentative, à un instant initial donné, de la variation de l'état de charge de la batterie pendant une occurrence de décharge ou de charge du cas d'usage sélectionné ;
- estimer l'état de santé énergétique de ladite batterie sur la base d'une comparaison entre la valeur témoin et la variation de l'état de charge à l'issue d'une occurrence du cas d'usage sélectionné.

Cette estimation de l'état de santé de la batterie, qui est obtenue hors-ligne ou « off-board » selon la terminologie anglo-saxonne, d'autres calculateurs que le BMS embarqué étant sollicité, est particulièrement avantageuse en ce qu'elle peut ainsi fournir une valeur de référence de l'état de santé de la batterie permettant de détecter une dérive potentielle de l'estimation en ligne de l'état de l'état de santé de la batterie, mise en oeuvre par des procédés connus dans le BMS embarqué.

Avantageusement, le procédé comprend des étapes préalables de :

- collecter des données d'usage d'un ensemble de véhicules incluant ledit véhicule électrique ou hybride, lesdites données étant relatives à au moins la distance de roulage parcourue à chaque occurrence de décharge ou à la durée de recharge à chaque occurrence de charge ;
- sélectionner ledit véhicule électrique ou hybride par application d'au moins un critère de filtrage des données d'usage collectées permettant de cibler un cas d'usage typique dudit véhicule électrique ou hybride.

Grâce au filtrage des données d'usage d'un ensemble de véhicule, il est possible de sélectionner un ou plusieurs véhicules cibles pour leur comportement de roulage régulier pour une période donnée et ainsi de cibler des occurrences de charge ou décharge pour lesquelles les données utiles au calcul de l'état de santé de la batterie peuvent être exploitées avec un degré de confiance le plus élevé possible.

Selon un mode de réalisation pour un cas d'usage typique ciblé incluant des occurrences de décharge, l'estimation de l'état de santé énergétique de la batterie est déterminée par la relation suivante :

$$SOHE = 100 \times \frac{\Delta SOC_{BOL}}{\Delta SOC}$$

où $\Delta SOC_{BOL}$ désigne ladite valeur témoin ;

$\Delta SOC$ est la variation de l'état de charge durant une occurrence de décharge considérée du cas d'usage typique ciblé.

Selon un autre mode de réalisation pour un cas d'usage typique ciblé incluant des occurrences de charge, l'estimation de l'état de santé énergétique de la batterie est déterminée par la relation suivante :

$$SOHE = 100 \times \frac{\Delta E_{ch}}{\Delta SOC} \times \frac{\Delta SOC_{BOL}}{\Delta E_{ch,BOL}}$$

où $\frac{\Delta E_{ch,BOL}}{\Delta SOC_{BOL}}$ désigne ladite valeur témoin, avec $\Delta E_{ch,BOL}$ correspondant à l'énergie chargée durant une occurrence de charge audit instant initial donné et $\Delta SOC_{BOL}$ désignant la variation d'état de charge de la batterie pendant cette occurrence de charge ; $\frac{\Delta E_{ch}}{\Delta SOC}$ représente le ratio de l'énergie chargée rapportée à la variation de l'état de charge durant une occurrence de charge considérée du cas d'usage typique ciblé.

Avantageusement, ledit au moins un critère de filtrage des données d'usage de véhicule peut être basé sur un nombre minimum d'occurrences de décharge ou de charge pour une période donnée.

Avantageusement, ledit au moins un critère de filtrage des données d'usage de véhicule peut être basé sur une durée d'usage cumulée minimum sur la période donnée.

Avantageusement, ladite valeur témoin correspond à une valeur représentative de la variation d'état de charge de la batterie en début de vie de la batterie.

Avantageusement, le procédé comprend une étape d'étalonnage de ladite valeur témoin en début de vie de la batterie.

Avantageusement, la variation de l'état de charge durant une occurrence du cas d'usage typique est obtenue par la détermination directe de l'état de charge à un instant de début et à un instant de fin de ladite occurence à partir des tensions aux bornes de la batterie en circuit ouvert auxdits instants de début et de fin

D'autres caractéristiques et avantages de l'invention ressortiront clairement de la description qui en est faite ci-après, à titre indicatif et nullement limitatif, en référence aux dessins annexés sur lesquels :

[Fig. 1] est un diagramme illustrant un exemple de répartition statistique de distances de roulage pour un véhicule donné ;

[Fig. 2] est un diagramme illustrant un exemple des grandeurs statistiques prise en compte pour la sélection du ou des véhicules cibles ;

[Fig. 3] est un diagramme illustrant un exemple de suivi d'un véhicule cible en termes de distances de roulage en fonction du temps.

Le principe de l'invention repose sur le fait qu'une large quantité de données d'usage de flotte ou d'un ensemble de véhicules est disponible et présente ainsi une richesse non négligeable pour réaliser un diagnostic hors-ligne des composants des véhicules électriques, en l'occurrence ici de la batterie.

On cherche en premier lieu à réaliser un filtrage de ces données d'usage, de manière à permettre de sélectionner un véhicule cible, ou un groupe de véhicules cibles, en raison de certaines particularités, notamment de régularité, de leur utilisation, et auxquels pourra s'appliquer le diagnostic hors-ligne de l'état de santé de leur batterie. On cible ici un profil de roulage répétitif, susceptible de découler d'une étude statistique du roulage tout au long de l'usage du véhicule.

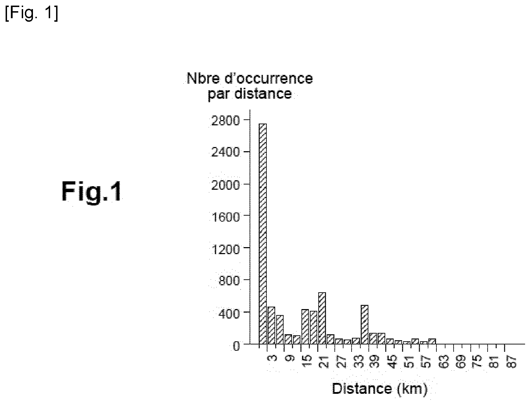

Ainsi, la figure 1 illustre un exemple de répartition statistique des distances de roulage, en kilomètre, pour un véhicule donné. On va d'abord sélectionner des données d'usage de ce véhicule sur la base de la distance de roulage parcourue traduisant un usage typique du véhicule. La distance de roulage ciblée est par exemple supérieure à une valeur minimale pour que la variation d'état de charge de la batterie qui en découle, en tant que donnée d'entrée utile au calcul de l'état de santé de la batterie, soit significative.

Pour la sélection des véhicules cibles, l'idée est de se rapprocher d'un cas de figure de banc de batterie où les conditions de mesure de la capacité seraient répétables. Ici, la répétabilité des conditions de mesure est assurée à travers un filtrage des données d'usage par des critères de filtrage devant être vérifiés pour sélectionner un véhicule cible.

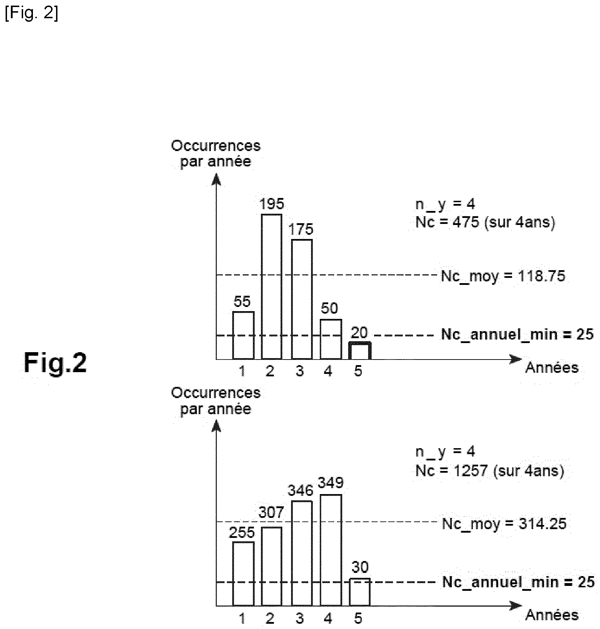

La figure 2 illustre un exemple des grandeurs statistiques pouvant être prises en compte en tant que critères de filtrage des données d'usage des véhicules pour la sélection du ou des véhicules cibles. L'exemple de la figure 2 se base sur une période de roulage minimum n_y de 4 ans, de façon à avoir un état de santé énergétique de la batterie présentant une dégradation visible.

Ainsi, à titre d'exemple, un nombre minimum Nc d'occurrence de décharge de la batterie sur la période de roulage donnée de 4 ans peut être vérifié pour sélectionner un véhicule cible. On peut également vérifier que le nombre d'occurrence de décharge par année sur la période de roulage donnée soit supérieur à un nombre minimum donné Nc_annuel_min, égal à 25 selon l'exemple. Le nombre d'occurrence de décharge par année doit par exemple satisfaire un minimum acceptable pour que le diagnostic soit conforme à l'hypothèse d'au moins deux occurrences de de décharge par mois.

On pourrait également prendre en compte en tant que critère de filtrage, la moyenne Nc_moy des occurrences de décharge par année sur la période de roulage donnée, pour le choix des véhicules cibles.

On pourrait également prendre en compte en tant que critère de filtrage, une durée d'utilisation cumulée minimum sur la période de roulage donnée, pour le choix des véhicules cibles.

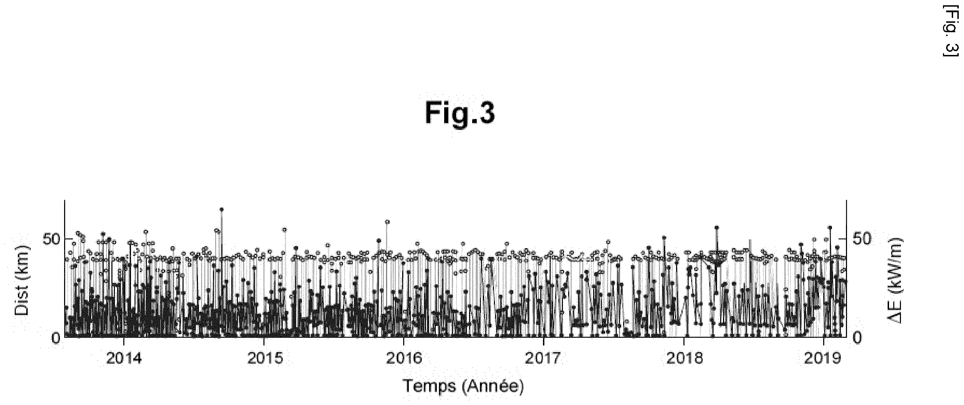

Après le choix du ou des véhicules cibles, on identifie pour chaque véhicule cible sur la période de roulage donnée, les occurrences de décharge de la batterie présentant sensiblement une même distance de roulage nominale. En référence à la figure 3, qui illustre un exemple de suivi d'un véhicule cible en termes de distances de roulage parcourue à chaque occurrence de décharge en fonction du temps, on peut observer que le véhicule cible parcourt régulièrement un trajet d'environ 40 km. A l'aide de la variation de l'état de charge de la batterie sur cette distance de roulage nominale représentative d'un trajet régulier effectué par le véhicule cible, on va pouvoir calculer le SOHE de la batterie du véhicule cible, comme il va être expliqué ci-après.

Cette distance nominale $d_{nom}$ est tout d'abord utilisée pour sélectionner les occurrences de décharge du véhicule cible correspondant à cette distance de roulage nominale, chaque occurrence de décharge ainsi sélectionnée définissant un trajet cible régulier du véhicule cible considéré sur la période de roulage donnée. Pour ce faire, on sélectionne les occurrences de décharge dont la distance de roulage d correspond à la distance nominale $d_{nom}$ avec une certaine tolérance $\Delta d$ :

$$d_{nom} - \Delta d < d < d_{nom} + \Delta d$$

En outre, on utilise un critère de sélection supplémentaire pour sélectionner ces trajets cibles réguliers. En l'occurrence, on sélectionne les occurrences de décharge correspondant à ces trajets cibles réguliers, qui sont suivies d'une période de repos supérieure à un temps de relaxation cible donné de la batterie.

Ce critère de sélection est particulièrement avantageux, dans la mesure où les états de charge de la batterie aux instants de début et de fin du trajet cible peuvent alors correspondre à des états relaxés de la batterie. Dans ce cas, l'état de charge SOC peut être directement calculé à partir de la tension aux bornes de la batterie en circuit ouvert OCV (de l'anglais « Open Circuit Voltage) et de la caractéristique SOC-OCV (SOC=f(OCV)).

En effet, dans la plupart des technologies de batterie, les périodes de charge et/ou de décharge de la batterie sont séparées par des périodes de relaxation, au cours desquelles la batterie n'est pas traversée par un courant. Au bout d'un certain temps de relaxation, la batterie atteint un état d'équilibre. Il est alors possible de mesurer la tension à vide de la batterie, qui correspond à sa force électromotrice à l'équilibre. Or, chaque force électromotrice à l'équilibre correspond à un état de charge précis, pour chaque type de batterie. Le temps de relaxation nécessaire pour atteindre l'état d'équilibre dépend du degré de polarisation des électrodes. Selon le type de batterie, un temps de relaxation de plusieurs minutes à plusieurs heures est nécessaire pour atteindre l'état d'équilibre.

Par exemple, on sélectionne les occurrences de décharge, qui sont suivies d'une période de repos supérieure à 2h.

La mesure de la force électromotrice à l'équilibre, durant les périodes de relaxation, permet donc de recaler l'estimation de l'état de charge proprement à partir de la caractéristique SOC = f(OCV).

En plus des critères de distance nominale et de temps de repos, la sélection des occurrences de décharge des véhicules cibles pourrait également prendre en compte un seuil d'état de charge minimum au début de l'occurrence de de décharge $SOC_{init,min}$. Autrement dit, on sélectionne les occurrences de décharge pour lesquelles l'état de charge de la batterie au début de l'occurrence de de décharge $SOC_{init}$ est supérieur au seuil minimum d'état de charge prédéfini, soit :

$$SOC_{init} > SOC_{init,min}$$

De la même façon, on pourrait aussi prendre en compte un seuil de variation d'état de charge minimum $\Delta SOC_{min}$ au cours de l'occurrence de décharge. Autrement dit, on sélectionne les occurrences de décharge pour lesquelles la variation d'état de charge de la batterie au cours de l'occurrence de décharge est supérieure au seuil minimum de variation d'état de charge prédéfini, soit :

$$|\Delta SOC| > \Delta SOC_{min}$$

L'intérêt de ce filtrage des données par véhicule cible est de permettre de réaliser l'estimation du SOHE en fonction de la variation de l'état de charge dans des conditions identiques ou à défaut similaires. La méthode de l'invention repose ainsi sur une maitrise des données utiles au calcul du SOHE par la sélection opérée.

Ainsi, une fois le filtrage des données par véhicule cible effectué, permettant de sélectionner les trajets cibles réguliers ou occurrences de décharge, suivis d'une période de repos de durée supérieure à un temps de relaxation cible donné de la batterie, on détermine une valeur témoin $\Delta SOC_{BOL}$ représentatif de la variation d'état de charge de la batterie sur le trajet cible à un instant initial :

$$\Delta SOC_{BOL} = SOC_{deb} - SOC_{fin}$$

où $SOC_{deb}$ et $SOC_{fin}$ représentent l'état de charge de la batterie respectivement au début et à la fin du trajet cible, en début de l'usage de la batterie. Ce début de l'usage de la batterie correspond au début de la vie de la batterie (BOL, de l'anglais « Beginning Of Life »).

A noter une période d'étalonnage de cette valeur témoin de l'état de santé de la batterie au début de la vie de la batterie, cette période pouvant être d'environ un an par exemple et étant calibrable en fonction de la chimie de la batterie. Ainsi, tant que l'âge de la batterie est inférieur à cet âge prédéfini de début de vie de la batterie, par exemple un an selon l'exemple, on stocke la variation d'état de charge de la batterie mesurée pour chaque trajet cible régulier donné pendant cette période.

Une moyenne pondérée pourra être appliquée aux mesures pour fixer la valeur du paramètre $\Delta SOC_{BOL}$ en début de vie de la batterie, en tant que valeur témoin.

Pour le calcul du SOHE hors-ligne, on fait l'hypothèse que, pour chaque trajet cible régulier donné, à température constante, la variation de l'état de charge de la batterie ne dépend que de son vieillissement. Aussi, étant donné que la distance de roulage parcourue pour les trajets sélectionnés est la même sur toute la période de roulage donnée, l'écart visible sur la variation de l'état de charge SOC nécessaire pour effectuer ces trajets constitue un témoin de la perte de capacité de la batterie et donc un témoin de la dégradation du SOHE.

Un filtrage est fait par la suite sur le nuage de points obtenu en fonction du temps, pour établir une loi de dégradation du SOHE.

Finalement le SOHE est déterminé par l'équation suivante :

$$SOHE = 100 \times \frac{\Delta SOC_{BOL}}{\Delta SOC}$$

où $\Delta SOC_{BOL}$ désigne la valeur témoin de l'état de santé en début de vie de la batterie, correspondant à la variation d'état de charge de la batterie sur le trajet cible en début de vie de la batterie et $\Delta SOC$ représente la variation de l'état de charge sur un trajet cible considéré.

Le mode de réalisation qui vient d'être décrit s'applique au calcul du SOHE à partir de la sélection d'un cas d'usage typique du véhicule, incluant des occurrences de décharge correspondant toujours à sensiblement une même distance de roulage, soit un même trajet cible régulier.

Toutefois, il peut exister des situations, telles que la vente du véhicule à un autre utilisateur, un changement de domicile, de lieu de travail ou un changement de comportement de l'utilisateur, qui impliquent un changement du trajet cible sélectionné du véhicule, soit de la distance nominale. Or, l'estimation de l'état de santé de la batterie en fonction de la variation de l'état de charge selon les principes exposés ci-dessus doit se faire dans des conditions identiques ou à défaut similaires.

Pour remédier au changement de distance nominale, la valeur témoin permettant d'estimer l'état de santé de la batterie en fonction de la variation de l'état de charge serait la variation d'état de charge par kilomètre parcouru. On obtient donc la formule suivante pour l'estimation de l'état de santé :

$$SOHE = 100 \times \frac{\Delta SOC_{BOL}}{d_{BOL}} \times \frac{d}{\Delta SOC}$$

où $d_{BOL}$ correspond à la distance parcourue pendant le trajet cible régulier en début de vie de la batterie et d la distance de roulage de l'occurrence de décharge sélectionnée.

Un autre mode de réalisation de l'invention concerne l'estimation du SOHE à partir de la sélection d'un cas d'usage typique du véhicule, incluant cette fois des occurrences de charge de la batterie correspondant toujours à sensiblement une même durée de recharge de la batterie lorsque le véhicule est branché à une borne de recharge de la batterie.

On vise ici à utiliser l'énergie chargée $\Delta E_{ch}$ (kWh) pendant une occurrence de charge comme indicateur de l'état de santé de la batterie. En effet, le calcul de l'énergie chargée dans la batterie lors de périodes de charge de la batterie implique de prendre en compte le courant de charge et la résistance interne de la batterie. Ainsi, l'évolution de l'énergie chargée au cours du vieillissement rend compte à la fois des deux phénomènes. Le ratio de l'énergie mesurée lors d'une charge de la batterie rapportée à sa valeur au début de vie (BOL) de la batterie permet d'estimer le SOHE.

Une étape de filtrage des données par véhicule cible choisi est d'abord mise en oeuvre pour sélectionner des occurrences de charge suivies d'une pause. Cette étape de filtrage vise à assurer une meilleure robustesse de l'estimation du SOHE. Ainsi, on utilise tout d'abord la durée de recharge comme critère de sélection pour sélectionner les occurrences de charge du véhicule cible dont la durée T est comprise entre une durée minimale Tmin et une durée maximale Tmax prédéfinies, soit :

$$T_{min} < T < T_{max}$$

Ce mode de réalisation implique également une sélection des occurrences de charge, qui sont suivies d'une période de repos supérieure à un temps de relaxation donné de la batterie, par exemple 2h. Ce temps de relaxation est calibrable et dépend de la chimie d la batterie et de la température. Les états de charge de la batterie aux instants de début et de fin de l'occurrence de charge correspondent alors à des états relaxés de la batterie. Dans ce cas, l'état de charge SOC peut être directement calculé à partir de la tension aux bornes de la batterie en circuit ouvert OCV selon les principes exposés précédemment.

En outre, on utilise d'autres critères de sélection pour sélectionner les occurrences de charge. Ainsi, la puissance de charge peut être utilisée pour sélectionner les occurrences de charge du véhicule cible dont la puissance de charge $P_{ch}$ correspond à une puissance de charge nominale $P_{ch,nom}$ avec une certaine tolérance $\Delta P$, soit :

$$P_{ch,nom} - \Delta P < P_{ch} < P_{ch,nom} + \Delta P$$

En effet, la puissance fait partie Les grandeurs de références qui impactent la valeur de l'énergie pendant la charge, avec la température et la profondeur de l'état de charge, autrement dit la durée de la charge.

Aussi, la sélection des occurrences de charge peut prendre en compte un seuil de variation d'état de charge minimum $\Delta SOC_{min}$ au cours de l'occurrence de charge. Autrement dit, on sélectionne les occurrences de charge pour lesquelles la variation d'état de charge de la batterie au cours de l'occurrence de charge est supérieure à un seuil minimum de variation d'état de charge prédéfini, soit :

$$|\Delta SOC| > \Delta SOC_{min}$$

A noter une période d'étalonnage de l'énergie cible au début de la vie de la batterie, cette période pouvant être d'environ un an par exemple et étant calibrable en fonction de la chimie de la batterie.

L'énergie chargée peut être mesurée de plusieurs façons différentes : soit obtenue en ligne par le BMS à l'aide de l'intégration du produit courant x tension, soit en mesurant la puissance instantanée à différents instants de la charge, cette information étant fournie hors ligne.

A l'issue de cette période d'étalonnage, on fixe la valeur du rapport $\frac{\Delta E_{ch,BOL}}{\Delta SOC_{BOL}}$ en début de vie de la batterie, en tant que valeur témoin représentative de l'état de santé de la batterie à cet instant initial donné, où $\Delta E_{ch,BOL}$ correspond à l'énergie chargée pendant une occurrence de charge sélectionnée en début de vie de la batterie et $\Delta SOC_{BOL}$ désigne la variation d'état de charge de la batterie pendant cette occurrence de charge.

Finalement le SOHE est déterminé par l'équation suivante :

$$SOHE = 100 \times \frac{\Delta E_{ch}}{\Delta SOC} \times \frac{\Delta SOC_{BOL}}{\Delta E_{ch,BOL}}$$

où $\frac{\Delta E_{ch}}{\Delta SOC}$ représente le ratio de l'énergie chargée rapportée à la variation de l'état de charge sur une occurrence de charge considérée.

**Revendications**

1. Procédé d'estimation de l'état de santé énergétique d'une batterie d'un véhicule électrique ou hybride comprenant une étape de calcul dudit état de santé à partir d'au moins un paramètre mesuré sur la batterie, dont son état de charge, le procédé étant **caractérisé en ce qu'**il comprend des étapes de :

   - sélectionner un cas d'usage typique du véhicule, incluant des occurrences de décharge correspondant toujours à sensiblement une même distance de roulage ou des occurrences de charge correspondant toujours à sensiblement une même durée de recharge à une borne de recharge, chaque occurrence de décharge ou de charge étant suivie d'une période de repos supérieure à un temps de relaxation donné de la batterie ;
   - déterminer une valeur témoin représentative, à un instant initial donné, de la variation de l'état de charge de la batterie pendant une occurrence de décharge ou de charge du cas d'usage sélectionné ;
   - estimer l'état de santé énergétique de ladite batterie sur la base d'une comparaison entre la valeur témoin et la variation de l'état de charge à l'issue d'une occurrence du cas d'usage sélectionné.

2. Procédé selon la revendication 1, **caractérisé en ce qu'**il comprend des étapes préalables de :

   - collecter des données d'usage d'un ensemble de véhicules incluant ledit véhicule électrique ou hybride, lesdites données étant relatives à au moins la distance de roulage parcourue à chaque occurrence de décharge ou à la durée de recharge à chaque occurrence de charge ;
   - sélectionner ledit véhicule électrique ou hybride par application d'au moins un critère de filtrage des données d'usage collectées permettant de cibler un cas d'usage typique dudit véhicule électrique ou hybride.

3. Procédé selon la revendication 2, **caractérisé en ce que** l'estimation de l'état de santé énergétique de la batterie est déterminée par la relation suivante pour un cas d'usage typique ciblé incluant des occurrences de décharge :

$$SOHE = 100 \times \frac{\Delta SOC_{BOL}}{\Delta SOC}$$

où $\Delta SOC_{BOL}$ désigne ladite valeur témoin ; $\Delta SOC$ est la variation de l'état de charge durant une occurrence de décharge considérée du cas d'usage typique ciblé.

4. Procédé selon la revendication 2, **caractérisé en ce que** l'estimation de l'état de santé énergétique de la batterie est déterminée par la relation suivante pour un cas d'usage typique ciblé incluant des occurrences de charge :

$$SOHE = 100 \times \frac{\Delta E_{ch}}{\Delta SOC} \times \frac{\Delta SOC_{BOL}}{\Delta E_{ch,BOL}}$$

où $\frac{\Delta E_{ch,BOL}}{\Delta SOC_{BOL}}$ désigne ladite valeur témoin, avec $\Delta E_{ch,BOL}$ correspondant à l'énergie chargée durant une occurrence de charge audit instant initial donné et $\Delta SOC_{BOL}$ désigne la variation d'état de charge de la batterie pendant cette occurrence de charge ; $\frac{\Delta E_{ch}}{\Delta SOC}$ représente le ratio de l'énergie chargée rapportée à la variation de l'état de charge durant une occurrence de charge considérée du cas d'usage typique ciblé.

5. Procédé selon l'une quelconque des revendications 2 à 4, **caractérisé en ce que** ledit au moins un critère de filtrage des données d'usage de véhicule est basé sur un nombre minimum d'occurrences de décharge ou de charge pour une période donnée.

6. Procédé selon la revendication précédente, **caractérisé en ce que** ledit au moins un critère de filtrage des données d'usage de véhicule est basé sur une durée d'usage cumulée minimum sur la période donnée.

7. Procédé selon l'une quelconque des revendications précédentes, **caractérisé en ce que** ladite valeur témoin correspond à une valeur représentative de la variation d'état de charge de la batterie en début de vie de la batterie.

8. Procédé selon la revendication 7, **caractérisé en ce qu'**il comprend une étape d'étalonnage de ladite valeur témoin en début de vie de la batterie.

9. Procédé selon l'une quelconque des revendications précédentes, **caractérisé en ce que** la variation de l'état de charge durant une occurrence du cas d'usage typique est obtenue par la détermination directe de l'état de charge à un instant de début et à un instant de fin de ladite occurrence à partir des tensions aux bornes de la batterie en circuit ouvert auxdits instants de début et de fin.

10. Procédé selon l'une quelconque des revendications précédentes, **caractérisé en ce qu'**on établit une loi de dégradation de l'état de santé de la batterie au cours du temps à partir des estimations de l'état de santé énergétique de la batterie.

**Patentansprüche**

1. Verfahren zur Schätzung des energetischen Intaktheitsstatus einer Batterie eines Elektro- oder Hybridfahrzeugs, das einen Schritt des Berechnens des Intaktheitsstatus anhand wenigstens eines an der Batterie gemessenen Parameters umfasst, darunter deren Ladezustand, wobei das Verfahren **dadurch gekennzeichnet ist, dass** es Folgende Schritte umfasst:

   - Auswählen eines typischen Anwendungsfalls des Fahrzeugs, der Entladungsereignisse, die immer im Wesentlichen einer gleichen Fahrdistanz entsprechen, oder Ladeereignisse, die immer im Wesentlichen einer gleichen Wiederaufladedauer an einer Wiederaufladestation entsprechen, beinhaltet, wobei auf jedes Entladungs- oder Ladeereignis eine Ruheperiode folgt, die größer als eine bestimmte Relaxationszeit der Batterie ist;
   - Bestimmen eines Kontrollwerts, der zu einem bestimmten Ausgangszeitpunkt für die Variation des Ladezustands der Batterie während eines Entladungs- oder Ladeereignisses des ausgewählten Anwendungsfalls repräsentativ ist;
   - Schätzen des energetischen Intaktheitsstatus der Batterie auf der Grundlage eines Vergleichs zwischen dem Kontrollwert und der Variation des Ladezustands nach einem Ereignis des ausgewählten Anwendungsfalls.

2. Verfahren nach Anspruch 1, **dadurch gekennzeichnet, dass** es folgende vorhergehende Schritte umfasst:

   - Sammeln von Nutzungsdaten einer Menge von Fahrzeugen, die das Elektro- oder Hybridfahrzeug beinhaltet, wobei sich die Daten wenigstens auf die zurückgelegte Fahrdistanz bei jedem Entladungsereignis oder auf die Wiederaufladedauer bei jedem Ladeereignis beziehen;
   - Auswählen des Elektro- oder Hybridfahrzeugs durch Anwendung wenigstens eines Kriteriums zur Filterung der gesammelten Nutzungsdaten, wodurch ein typischer Anwendungsfall des Elektro- oder Hybridfahrzeugs anvisiert werden kann.

3. Verfahren nach Anspruch 2, **dadurch gekennzeichnet, dass** die Schätzung des energetischen Intaktheitsstatus der Batterie durch die folgende Beziehung für einen anvisierten typischen Anwendungsfall bestimmt wird, der Entladungsereignisse beinhaltet:

$$SOHE = 100 \times \frac{\Delta SOC_{BOL}}{\Delta SOC}$$

wobei $\Delta SOC_{BOL}$ den Kontrollwert bezeichnet; $\Delta SOC$ die Variation des Ladezustands während eines betrachteten Entladungsereignisses des anvisierten typischen Anwendungsfalls ist.

4. Verfahren nach Anspruch 2, **dadurch gekennzeichnet, dass** die Schätzung des energetischen Intaktheitsstatus der Batterie durch die folgende Beziehung für einen anvisierten typischen Anwendungsfall bestimmt wird, der Ladeereignisse beinhaltet:

$$SOHE = 100 \times \frac{\Delta E_{ch}}{\Delta SOC} \times \frac{\Delta SOC_{BOL}}{\Delta E_{ch,BOL}}$$

wobei $\frac{\Delta E_{ch,BOL}}{\Delta SOC_{BOL}}$ den Kontrollwert bezeichnet, wobei $\Delta E_{ch,BOL}$ der Energie entspricht, die während des Ladeereignisses zum bestimmten Ausgangszeitpunkt geladen wird, und $\Delta SOC_{BOL}$ die Ladezustandsvariation der Batterie während dieses Ladeereignisses bezeichnet; $\frac{\Delta E_{ch}}{\Delta SOC}$ das Verhältnis der geladenen Energie zur Variation des Ladezustands während eines betrachteten Ladeereignisses des anvisierten typischen Anwendungsfalls darstellt.

5. Verfahren nach einem der Ansprüche 2 bis 4, **dadurch gekennzeichnet, dass** das wenigstens eine Kriterium zur Filterung der Fahrzeugnutzungsdaten auf einer Mindestanzahl von Entladungs- oder Ladeereignissen für einen bestimmten Zeitraum beruht.

**6.** Verfahren nach dem vorhergehenden Anspruch, **dadurch gekennzeichnet, dass** das wenigstens eine Kriterium zur Filterung der Fahrzeugnutzungsdaten auf einer kumulierten Mindestnutzungsdauer in dem bestimmten Zeitraum beruht.

**7.** Verfahren nach einem der vorhergehenden Ansprüche, **dadurch gekennzeichnet, dass** der Kontrollwert einem Wert entspricht, der für die Ladezustandsvariation der Batterie zu Beginn der Lebensdauer der Batterie repräsentativ ist.

**8.** Verfahren nach Anspruch 7, **dadurch gekennzeichnet, dass** es einen Schritt des Kalibrierens des Kontrollwerts zu Beginn der Lebensdauer der Batterie umfasst.

**9.** Verfahren nach einem der vorhergehenden Ansprüche, **dadurch gekennzeichnet, dass** die Variation des Ladezustands während eines Ereignisses des typischen Anwendungsfalls durch die direkte Bestimmung des Ladezustands zu einem Anfangszeitpunkt und einem Endzeitpunkt des Ereignisses anhand der Spannungen an den Anschlüssen der Batterie im Leerlauf zum Anfangs- und Endzeitpunkt erhalten wird.

**10.** Verfahren nach einem der vorhergehenden Ansprüche, **dadurch gekennzeichnet, dass** ein Gesetz der Verschlechterung des Intaktheitsstatus der Batterie im Zeitverlauf anhand der Schätzungen des energetischen Intaktheitsstatus der Batterie aufgestellt wird.

**Claims**

**1.** Method for estimating the energy state of health of a battery of an electric or hybrid vehicle, comprising a step of calculating said state of health on the basis of at least one parameter measured on the battery, including its state of charge, the method being **characterized in that** it comprises steps of:

- selecting a case of typical use of the vehicle, including discharging occurrences always corresponding to substantially the same travel distance or charging occurrences always corresponding to substantially the same period of recharging at a recharging terminal, each discharging or charging occurrence being followed by a rest period which is longer than a given relaxation time for the battery;
- determining a control value which is representative, at a given initial instant, of the variation in the state of charge of the battery during a discharging or charging occurrence of the case of use selected;
- estimating the energy state of health of said battery on the basis of a comparison between the control value and the variation in the state of charge at the end of an occurrence of the case of use selected.

**2.** Method according to Claim 1, **characterized in that** it comprises prior steps of:

- collecting use data from a set of vehicles including said electric or hybrid vehicle, said data relating to at least the travel distance covered at each discharging occurrence or to the recharging period at each charging occurrence;
- selecting said electric or hybrid vehicle by applying at least one criterion for filtering the use data collected which makes it possible to target a case of typical use of said electric or hybrid vehicle.

**3.** Method according to Claim 2, **characterized in that** the estimate of the energy state of health of the battery is determined by the following relationship for a targeted case of typical use including discharging occurrences:

$$SOHE = 100 \times \frac{\Delta SOC_{BOL}}{\Delta SOC}$$

where $\Delta SOC_{BOL}$ denotes said control value; $\Delta SOC$ is the variation in the state of charge during a discharging occurrence, of the targeted case of typical use, under consideration.

**4.** Method according to Claim 2, **characterized in that** the estimate of the energy state of health of the battery is determined by the following relationship for a targeted case of typical use including charging occurrences:

$$SOHE = 100 \times \frac{\Delta E_{ch}}{\Delta SOC} \times \frac{\Delta SOC_{BOL}}{\Delta E_{ch,BOL}}$$

where $\frac{\Delta E_{ch,BOL}}{\Delta SOC_{BOL}}$ denotes said control value, with $\Delta E_{ch,BOL}$ corresponding to the energy charged during a charging occurrence at said given initial instant and $\Delta SOC_{BOL}$ denotes the variation in the state of charge of the battery during this charging occurrence; $\frac{\Delta E_{ch}}{\Delta SOC}$ represents the ratio of the energy charged to the variation in the state of charge during a charging occurrence, of the targeted case of typical use, under consideration.

5. Method according to any one of Claims 2 to 4, **characterized in that** said at least one criterion for filtering the vehicle use data is based on a minimum number of discharging or charging occurrences for a given period.

6. Method according to the preceding claim, **characterized in that** said at least one criterion for filtering the vehicle use data is based on a minimum cumulative use time over the given period.

7. Method according to any one of the preceding claims, **characterized in that** said control value corresponds to a value which is representative of the variation in the state of charge of the battery at the beginning of the life of the battery.

8. Method according to Claim 7, **characterized in that** it comprises a step of calibrating said control value at the beginning of the life of the battery.

9. Method according to any one of the preceding claims, **characterized in that** the variation in the state of charge during an occurrence of the case of typical use is obtained by directly determining the state of charge at a beginning instant and at an end instant of said occurrence on the basis of the voltages across the terminals of the battery in an open circuit at said beginning and end instants.

10. Method according to any one of the preceding claims, **characterized in that** a law of degradation of the state of health of the battery over time is established on the basis of the estimates of the energy state of health of the battery.

[Fig. 1]

Fig.1

[Fig. 2]

Fig.2

Occurrences par année

195
175
55
50
20

n_y = 4
Nc = 475 (sur 4ans)

Nc_moy = 118.75

Nc_annuel_min = 25

1 2 3 4 5    Années

Occurrences par année

346 349
307
255
30

n_y = 4
Nc = 1257 (sur 4ans)

Nc_moy = 314.25

Nc_annuel_min = 25

1 2 3 4 5    Années

[Fig. 3]

Fig.3

**EP 4 111 219 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2011112781 A
- FR 2967786 A1
- WO 2015169717 A1
- US 2009128097 A1
- US 10401433 B2